# EUROPEAN PATENT APPLICATION

(11) **EP 1 850 483 A2**
(43) Date of publication of application: **31.10.2007**
(21) Application number: 07008259.9
(22) Date of filing: 24.04.2007
(51) Int. Cl.: H03K 19/0185

(54) **Signal converter circuit**

(30) Priority: 28.04.2006 US 413315
(71) Applicant: Qimonda AG, 81739 München (DE)
(72) Inventor: Schuhmacher, Otto, 85221 Dachau (DE); Blum, Andreas, 80799 München (DE); Gopalakrishnan, Karthik, San Jose CA 95135 (US); Partovi, Hamid, Sunnyvale CA 94087 (US); Ravezzi, Luca, Palo Alto CA 94306 (US)
(74) Representative: Banzer, Hans-Jörg

(57) **Abstract**

A signal converter circuit (28) including an input circuit (32) and an output circuit (34). The input circuit (32) is configured to receive current mode logic signals (38; 300, 302) and provide differential input signals (36; 304, 306) based on the current mode logic signals (38; 300, 302). The output circuit (34) is configured to receive the differential input signals (36; 304, 306) and provide rail-to-rail output signals (30; 314, 316) based on the differential input signals (36; 304, 306). The output circuit (34) is configured to switch the rail-to-rail output signals (30; 314, 316) in response to a common edge type in each of the differential input signals (36; 304, 306).

## Description

### Background

Typically, a computer system includes a number of integrated circuits that communicate with one another to perform system applications. Often, the computer system includes one or more host controllers and one or more electronic subsystem assemblies, such as a dual in-line memory module (DIMM), a graphics card, an audio card, a facsimile card, and a modem card. To perform system functions, the host controller(s) and subsystem assemblies communicate via communication links, such as serial communication links. Serial communication links include links that implement the fully buffered DIMM (FB-DIMM) advanced memory buffer (AMB) standard, the peripheral component interconnect express (PCIe) standard, or any other suitable serial communication link system.

An AMB chip is a key device in an FB-DIMM. An AMB has two serial links, one for upstream traffic and the other for downstream traffic, and a bus to on-board memory, such as dynamic random access memory (DRAM) in the FB-DIMM. Serial data from a host controller sent through the downstream serial link (southbound) is temporarily buffered, and can then be sent to memory in the FB-DIMM. The serial data contains the address, data, and command information given to the memory, converted in the AMB, and sent to the memory bus. The AMB writes in and reads out data from the memory as instructed by the host controller. The read data is converted to serial data, and sent back to the host controller on the upstream serial link (northbound).

An AMB also performs as a repeater between FB-DIMMs on the same channel. The AMB transfers information from a primary southbound link connected to the host controller or an upper AMB to a lower AMB in the next FB-DIMM via a secondary southbound link. The AMB receives information in the lower FB-DIMM from a secondary northbound link, and after merging the information with information of its own, sends it to the upper AMB or host controller via a primary northbound link. This forms a daisy-chain among FB-DIMMs. A key attribute of the FB-DIMM channel architecture is the high-speed, serial, point-to-point connection between the host controller and FB-DIMMs on the channel. The AMB standard is based on serial differential signaling.

PCIe is also a high-speed, serial link that communicates data via differential signal pairs. A PCIe link is built around a bidirectional, serial, point-to-point connection known as a "lane". At the electrical level, each lane utilizes two unidirectional low voltage differential signaling pairs, a transmit pair and a receive pair, for a total of four data wires per lane. A connection between any two PCIe devices is known as a link, and is built up from a collection of one or more lanes. All PCIe devices minimally support single-lane (x1) links. Devices may optionally support wider links composed of x2, x4, x8, x12, x16, x32, or more lanes.

High speed communication links, such as AMB and PCIe links, often use low swing current mode logic (CML) signals to communicate data. Since signal processing is typically accomplished via high swing, rail-to-rail complementary metal oxide semiconductor (CMOS) circuits, the CML signals are converted to CMOS logic level signals via signal converter circuits to process the received data. At high speeds, the signal converter circuits may suffer from pulse width and duty cycle distortion, which can lead to unreliable communications between devices. Also, the pulse width and duty cycle distortion often increases with changes in the process, voltage, and/or temperature parameters, which leads to a greater chance of unreliable communications between devices.

For these and other reasons there is a need of the present invention.

An object of the present invention is to provide a signal converter circuit and a method providing a reliable communication between devices.

### Summary

According to the present invention this object is achieved by a signal converter circuit as defined in claims 1 and 13, a current mode logic signal to rail-to-rail signal converter circuit as defined in claim 8, and a method of converting current mode logic signals to rail-to-rail signals as defined in claims 19 and 24. The dependent claims define preferred and advantageous embodiments of the present invention.

One aspect of the present invention provides a signal converter circuit including an input circuit and an output circuit. The input circuit is configured to receive current mode logic signals and provide differential input signals based on the current mode logic signals. The output circuit is configured to receive the differential input signals and provide rail-to-rail output signals based on the differential input signals. The output circuit is configured to switch the rail-to-rail output signals in response to a common edge type in each of the differential input signals.

### Brief Description of the Drawings

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
Figure 1 a diagram illustrating one embodiment of a computer system according to the present invention.
Figure 2 is a diagram illustrating one embodiment of a signal converter circuit.
Figure 3 is a diagram illustrating one embodiment of a converter input circuit.
Figure 4 is a diagram illustrating one embodiment of a converter output circuit.
Figure 5 is a timing diagram illustrating the operation of one embodiment of a signal converter circuit.
Figure 6 is a diagram illustrating the duty cycles of a positive/negative gate drive signal and a positive/negative rail-to-rail CMOS signal over power.
Figure 7 is a process, voltage, and temperature corner analysis table for the duty cycle of rail-to-rail output signals in one embodiment of a signal converter circuit.
Figure 8 is a diagram illustrating the results of a Monte Carlo analysis that indicates the effects of mismatch in one embodiment of a signal converter circuit.

### Detailed Description

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments of the present invention can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

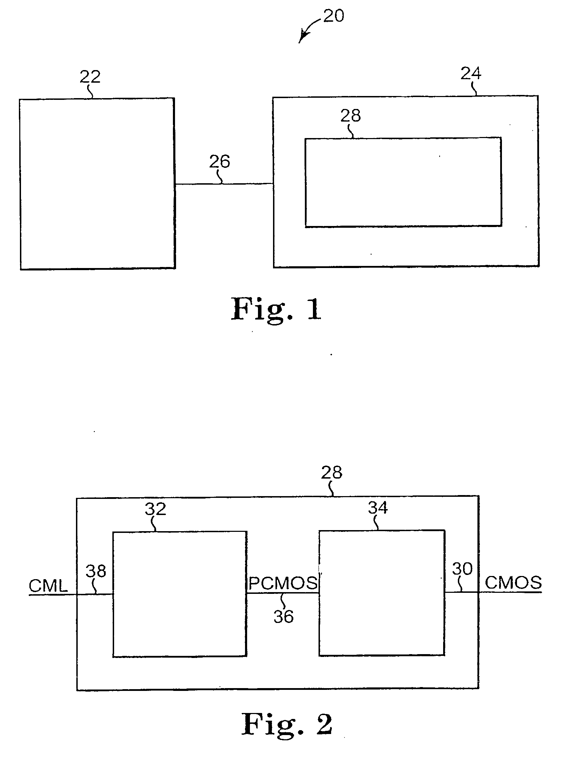

Figure 1 is a diagram illustrating one embodiment of a computer system 20 according to the present invention. Computer system 20 includes a host controller 22 and a subsystem assembly 24. Host controller 22 is electrically coupled to subsystem assembly 24 via communications link 26. Host controller 22 controls subsystem assembly 24 via communications link 26 to provide a system function. In one embodiment, host controller 22 is a memory controller. In one embodiment, subsystem assembly 24 is an FB-DIMM and host controller 22 controls the FB-DIMM to provide a system memory function. In other embodiments, subsystem assembly 24 is any suitable subsystem assembly, such as a graphics card, an audio card, a facsimile card, or a modem card, and host controller 22 controls subsystem assembly 24 to provide the corresponding system function.

Subsystem assembly 24 includes a signal converter circuit 28 that receives CML signals and converts the CML signals to rail-to-rail output signals. The rail-to-rail output signals, referred to herein as CMOS output signals, include low logic levels at substantially VSS and high logic levels at substantially VDD. Signal converter circuit 28 provides the CMOS output signals to CMOS circuits in subsystem assembly 24 to process received data.

In one embodiment, signal converter circuit 28 receives CML signals from a CML signal sampler, where subsystem assembly 24 receives CML signals from host controller 22 via communications link 26. A pre-amplifier and the CML signal sampler are situated between communications link 26 and signal converter circuit 28 in subsystem assembly 24. The CML signal sampler receives and samples CML signals and signal converter circuit 28 receives CML signals from the CML signal sampler.

In one embodiment, signal converter circuit 28 receives CML signals, such as CML clock signals, from a circuit in subsystem assembly 24. In other embodiments, signal converter circuit 28 receives CML signals from any suitable source of CML signals.

Signal converter circuit 28 provides differential input signals that correspond to the CML signals. The signal converter circuit 28 switches the CMOS output signals in response to a common edge type, such as falling edges or rising edges, in each of the differential input signals. Switching the CMOS output signals in response to a common edge type in the differential input signals reduces pulse width and duty cycle distortion in the CMOS output signals. In one embodiment, signal converter circuit 28 switches the CMOS output signals to one state in response to a falling edge in one of the differential input signals and switches the CMOS output signals to another state in response to a falling edge in the other one of the differential input signals.

In one embodiment, signal converter circuit 28 receives CML signals and provides differential input signals that correspond to the CML signals, where signal converter circuit 28 provides a common mode voltage in the differential input signals that is substantially equal to a threshold value of a CMOS inverter. In one embodiment, signal converter circuit 28 receives CML signals and provides differential input signals that correspond to the CML signals, where signal converter circuit 28 provides a differential voltage swing in the differential input signals that is larger than the CML differential voltage swing.

Communications link 26 includes one or more differential signal pairs that communicate data between host computer 22 and subsystem assembly 24. In one embodiment, communications link 26 includes one differential signal pair. In one embodiment, communications link 26 includes multiple differential signal pairs that communicate data bi-directionally via communications link 26.

In one embodiment, subsystem assembly 24 is an FB-DIMM that is one of multiple FB-DIMMs daisy-chained to host controller 22 via communications link 26. Each of the daisy-chained FB-DIMMs includes an AMB that provides an FB-DIMM AMB serial communications link. The FB-DIMM AMB serial communications link includes CML signals in the differential pairs of communications link 26. Each of the FB-DIMMs includes one or more signal converter circuits 28 that receive CML signals and convert the CML signals to CMOS output signals. The signal converter circuits 28 provide the CMOS output signals to CMOS circuits in the FB-DIMM subsystem assembly 24 to process received data.

In one embodiment, host controller 22 and subsystem assembly 24 provide a PCIe serial communications link in communications link 26. The PCIe serial communications link is an AC-coupled interface that includes CML signals in the differential pairs of communications link 26. Each subsystem assembly 24 includes one or more signal converter circuits 28 that receive CML signals and convert the CML signals to CMOS output signals. The signal converter circuits 28 provide the CMOS output signals to CMOS circuits in subsystem assembly 24 to process the received data. In other embodiments, host controller 22 and subsystem assembly 24 communicate via any suitable communications link.

Figure 2 is a diagram illustrating one embodiment of signal converter circuit 28, which receives CML signals via input path 38 and provides CMOS output signals via output path 30. Signal converter circuit 28 includes a converter input circuit 32 electrically coupled to a converter output circuit 34 via differential input signal path 36.

Input circuit 32 receives CML signals at 38 and provides differential input signals PCMOS at 36. Differential input signals PCMOS at 36 are pseudo-CMOS logic level signals that correspond to CML signals at 38. Input circuit 32 provides a differential voltage swing in differential input signals PCMOS at 36 that is larger than the differential voltage swing in CML signals at 38. Input circuit 32 also provides a common mode voltage in differential input signals PCMOS at 36, which is substantially equal to a CMOS threshold value. Differential input signals PCMOS at 36 are provided to reliably drive CMOS circuits in output circuit 34.

Output circuit 34 receives differential input signals PCMOS at 36 and provides CMOS output signals at 30. Output circuit 34 switches CMOS output signals at 30 in response to a common edge type, such as a falling edge type or a rising edge type, in each of the differential input signals PCMOS at 36. Switching CMOS output signals at 30 in response to a common edge type in differential input signals PCMOS at 36 reduces pulse width and duty cycle distortion in CMOS output signals at 30.

In one embodiment, output circuit 34 switches CMOS output signals at 30 to one state in response to a falling edge in one of the differential input signals PCMOS at 36 and output circuit 34 switches CMOS output signals at 30 to another state in response to a falling edge in the other one of the differential input signals PCMOS. In one embodiment, output circuit 34 switches CMOS output signals at 30 to one state in response to a rising edge in one of the differential input signals PCMOS at 36 and output circuit 34 switches CMOS output signals at 30 to another state in response to a rising edge in the other one of the differential input signals PCMOS at 36.

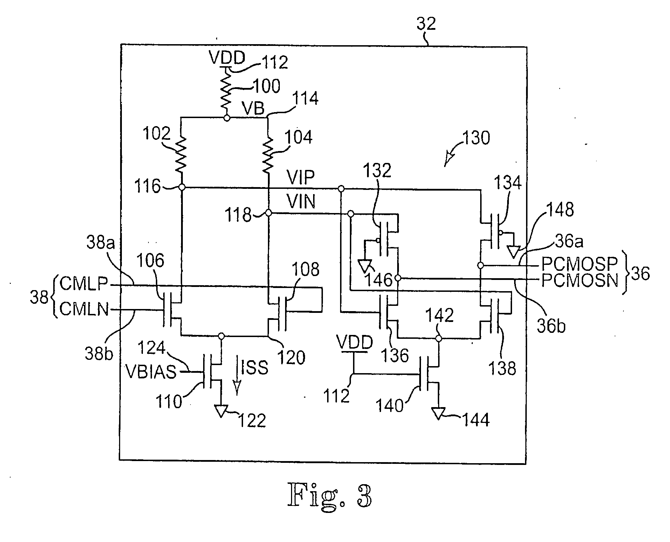

Figure 3 is a diagram illustrating one embodiment of a converter input circuit 32 that receives differential CML signals at 38 and provides differential input signals via differential input signal path 36. Input circuit 32 receives a positive CML signal CMLP at 38a and a negative CML signal CMLN at 38b. Input circuit 32 provides a positive differential input signal PCMOSP at 36a and a negative differential input signal PCMOSN at 36b. Input circuit 32 provides a differential voltage swing in differential input signals PCMOSP at 36a and PCMOSN at 36b that is larger than the differential voltage swing in CML signals CMLP at 38a and CMLN at 38b. Input circuit 32 also provides a common mode voltage in differential input signals PCMOSP at 36a and PCMOSN at 36b, which is substantially equal to a CMOS threshold value, such as the threshold value of a CMOS inverter. Differential input signals PCMOSP at 36a and PCMOSN at 36b are provided to reliably drive CMOS circuits in output circuit 34.

Input circuit 32 includes a common mode resistor 100, a first load resistor 102, a second load resistor 104, a differential pair of input transistors, negative input transistor 106 and positive input transistor 108, and a bias transistor 110. Negative input transistor 106 and positive input transistor 108 are n-channel metal oxide semiconductor (NMOS) transistors.

One side of common mode resistor 100 is electrically coupled to power VDD at 112. The other side of common mode resistor 100 is electrically coupled to one side of first load resistor 102 and one side of second load resistor 104 via conductive path 114. The other side of first load resistor 102 is electrically coupled to one side of the drain-source path of negative input transistor 106 via positive signal path 116. The other side of second load resistor 104 is electrically coupled to one side of the drain-source path of positive input transistor 108 via negative signal path 118.

The other side of the drain-source path of negative input transistor 106 is electrically coupled to the other side of the drain-source path of positive input transistor 108 and one side of the drain-source path of bias transistor 110 via common source path 120. The other side of the drain-source path of bias transistor 110 is electrically coupled to a reference, such as ground, at 122. The gate of bias transistor 110 is electrically coupled to a bias voltage VBIAS via gate path 124, which turns on bias transistor 110 to provide a current source for current ISS. The gate of negative input transistor 106 is electrically coupled to receive negative CML signal CMLN at 38b and the gate of positive input transistor 108 is electrically coupled to receive positive CML signal CMLP at 38a.

Positive and negative CML signals at 38a and 38b are differential signals, where the positive CML signal CMLP at 38a is one of high or low and the negative CML signal CMLN at 38b is the other one of high or low. Positive input transistor 108 receives positive CML signal CMLP at 38a and negative input transistor 106 receives negative CML signal CMLN at 38b. The negative and positive input transistors 106 and 108 steer current ISS through one of first load resistor 102 or second load resistor 104. The current ISS flows from power VDD at 112 through common mode resistor 100 and one of first load resistor 102 or second load resistor 104. Buffer voltage VB at 114 is less than or equal to VDD minus the quantity of ISS times the value of common mode resistor 100. Also, buffer voltage VB at 114 is set via the value of current ISS and the value of common mode resistor 100 to be a sufficiently high voltage level to maintain positive and negative input transistors 106 and 108 in the saturation region.

If the positive CML signal CMLP at 38a is high and the negative CML signal CMLN at 38b is low, negative input transistor 106 is biased off and positive input transistor 108 is biased on to steer current ISS through second load resistor 104. Buffer voltage VB at 114 is less than or equal to VDD minus the quantity of ISS times the value of common mode resistor 100. The negative internal voltage VIN at 118 is less than or equal to buffer voltage VB at 114 minus the quantity of current ISS times the value of second load resistor 104. The positive internal voltage VIP at 116 is substantially equal to buffer voltage VB at 114.

If positive CML signal CMLP at 38a is low and negative CML signal CMLN at 38b is high, positive input transistor 108 is biased off and negative input transistor 106 is biased on to steer current ISS through first load resistor 102. Buffer voltage VB at 114 is less than or equal to VDD minus the quantity of ISS times the value of common mode resistor 100. Positive internal voltage VIP at 116 is less than or equal to buffer voltage VB at 114 minus the quantity of current ISS times the value of first load resistor 102. Negative internal voltage VIN at 118 is substantially equal to buffer voltage VB at 114.

Input circuit 32 also includes a regenerative circuit, indicated at 130. Regenerative circuit 130 includes a first p-channel metal oxide semiconductor (PMOS) transistor 132, a second PMOS transistor 134, a differential pair of NMOS output transistors, first NMOS output transistor 136 and second NMOS output transistor 138, and a bias transistor 140. One side of the drain-source path of first PMOS transistor 132 is electrically coupled to one side of the drain-source path of positive input transistor 108 and the gate of second NMOS output transistor 138 via negative signal path 118. One side of the drain-source path of second PMOS transistor 134 is electrically coupled to one side of the drain-source path of negative input transistor 106 and the gate of first NMOS output transistor 136 via positive signal path 116. The other side of the drain-source path of first PMOS transistor 132 is electrically coupled to one side of the drain-source path of first NMOS output transistor 136 via negative differential input signal path 36b. The other side of the drain-source path of second PMOS transistor 134 is electrically coupled to one side of the drain-source path of second NMOS output transistor 138 via positive differential input signal path 36a.

The other side of the drain-source path of first NMOS output transistor 136 is electrically coupled to the other side of the drain-source path of second NMOS output transistor 138 and one side of the drain-source path of bias transistor 140 via common source path 142. The other side of the drain-source path of bias transistor 140 is electrically coupled to a reference, such as ground, at 144. The gate of bias transistor 140 is electrically coupled to receive power VDD at 112, which turns on bias transistor 140 to provide a small resistance. The gate of first PMOS transistor 132 is electrically coupled to a reference, such as ground, at 146 to turn on first PMOS transistor 132. The gate of second PMOS transistor 134 is electrically coupled to a reference, such as ground, at 148 to turn on second PMOS transistor 134.

Positive and negative internal voltages VIP at 116 and VIN at 118 are differential signals, where the positive internal voltage VIP at 116 is one of high or low and the negative internal voltage VIN at 118 is the other one of high or low. The drain-source path of second PMOS transistor 134 and the gate of first NMOS output transistor 136 receive positive internal voltage VIP at 116. The drain-source path of first PMOS transistor 132 and the gate of second NMOS output transistor 138 receive negative internal voltage VIN at 118.

If positive internal voltage VIP at 116 is high and negative internal voltage VIN at 118 is low, first NMOS output transistor 136 is biased on and second NMOS output transistor 138 is biased off. First NMOS output transistor 136 pulls negative differential input signal PCMOSN at 36b to a low voltage level. If negative internal voltage VIN at 118 is at a low voltage level and negative differential input signal PCMOSN at 36b is at a low voltage level, the resistance of first PMOS transistor 132 becomes an exceedingly high resistance value that isolates negative differential input signal PCMOSN at 36b from negative internal voltage VIN at 118. This inhibits negative internal voltage VIN at 118 from driving positive input transistor 108 into the linear region. Negative internal voltage VIN at 118 is clamped to be greater than or equal to the threshold voltage of first PMOS transistor 132. The positive differential input signal PCMOSP at 36a is substantially pulled to positive internal voltage VIP at 116 and buffer voltage VB at 114 via second PMOS transistor 134.

If positive internal voltage VIP at 116 is low and negative internal voltage VIN at 118 is high, first NMOS output transistor 136 is biased off and second NMOS output transistor 138 is biased on. Second NMOS output transistor 138 pulls positive differential input signal PCMOSP at 36a to a low voltage level. If positive internal voltage VIP at 116 is at a low voltage level and positive differential input signal PCMOSP at 36a is at a low voltage level, the resistance of second PMOS transistor 134 becomes an exceedingly high resistance value that isolates positive differential input signal PCMOSP at 36a from positive internal voltage VIP at 116. This inhibits positive internal voltage VIP at 116 from driving negative input transistor 106 into the linear region. Positive internal voltage VIP at 116 is clamped to be greater than or equal to the threshold voltage of second PMOS transistor 134. The negative differential input signal PCMOSN at 36b is substantially pulled to negative internal voltage VIN at 118 and buffer voltage VB at 114 via first PMOS transistor 132.

Isolation of negative differential input signal PCMOSN at 36b from negative internal voltage VIN at 118 allows negative differential input signal PCMOSN at 36b to go to a lower voltage level than negative internal voltage VIN at 118. Also, isolation of positive differential input signal PCMOSP at 36a from positive internal voltage VIP at 116 allows positive differential input signal PCMOSP at 36a to go to a lower voltage level than positive internal voltage VIP at 116. Thus, positive and negative differential input signals PCMOSP at 36a and PCMOSN at 36b have a larger differential voltage swing than positive and negative internal voltages VIP at 116 and VIN at 118.

First and second NMOS output transistors 136 and 138 and bias transistor 140 are sized to pull positive and negative differential input signals PCMOSP at 36a and PCMOSN at 36b to a low voltage level and provide a pseudo-CMOS voltage swing. Also, bias transistor 140 operates as a resistor to provide a suitable common mode voltage in positive and negative internal voltages VIP at 116 and VIN at 118 to maintain positive and negative input transistors 106 and 108 in the saturation region. In addition, bias transistor 140 operates as a resistor to provide a suitable common mode voltage level in positive and negative differential input signals PCMOSP at 36a and PCMOSN at 36b.

In operation, positive input transistor 108 receives positive CML signal CMLP at 38a and negative input transistor 106 receives negative CML signal CMLN at 38b.

If positive CML signal CMLP at 38a is low and negative CML signal CMLN at 38b is high, positive input transistor 108 is biased off and negative input transistor 106 is biased on to steer current ISS through first load resistor 102. Positive internal voltage VIP at 116 is at a low voltage level and negative internal voltage VIN at 118 is at a high voltage level, substantially equal to buffer voltage VB at 114.

If the positive CML signal CMLP at 38a is high and the negative CML signal CMLN at 38b is low, negative input transistor 106 is biased off and positive input transistor 108 is biased on to steer current ISS through second load resistor 104. The negative internal voltage VIN at 118 is at a low voltage level and the positive internal voltage VIP at 116 is at a high voltage level, substantially equal to buffer voltage VB at 114.

If positive internal voltage VIP at 116 is high and negative internal voltage VIN at 118 is low, first NMOS output transistor 136 is biased on and second NMOS output transistor 138 is biased off. First NMOS output transistor 136 pulls negative differential input signal PCMOSN at 36b to a low voltage level. Second PMOS transistor 134 pulls positive differential input signal PCMOSP at 36a to a high voltage level that is substantially equal to positive internal voltage VIP at 116 and buffer voltage VB at 114.

If positive internal voltage VIP at 116 is low and negative internal voltage VIN at 118 is high, first NMOS output transistor 136 is biased off and second NMOS output transistor 138 is biased on. Second NMOS output transistor 138 pulls positive differential input signal PCMOSP at 36a to a low voltage level. First PMOS transistor 132 pulls negative differential input signal PCMOSN at 36b to a high voltage level that is substantially equal to negative internal voltage VIN at 118 and buffer voltage VB at 114.

Input circuit 32 provides pseudo-CMOS logic level signals of positive and negative differential input signals PCMOSP at 36a and PCMOSN at 36b. Input circuit 32 provides a differential voltage swing in positive and negative differential input signals PCMOSP at 36a and PCMOSN at 36b that is larger than the differential voltage swing in CML signals at 38. Input circuit 32 also provides a common mode voltage in positive and negative differential input signals PCMOSP at 36a and PCMOSN at 36b that is substantially equal to a CMOS threshold value. Positive and negative differential input signals PCMOSP at 36a and PCMOSN at 36b are provided to reliably drive CMOS circuits in output circuit 34.

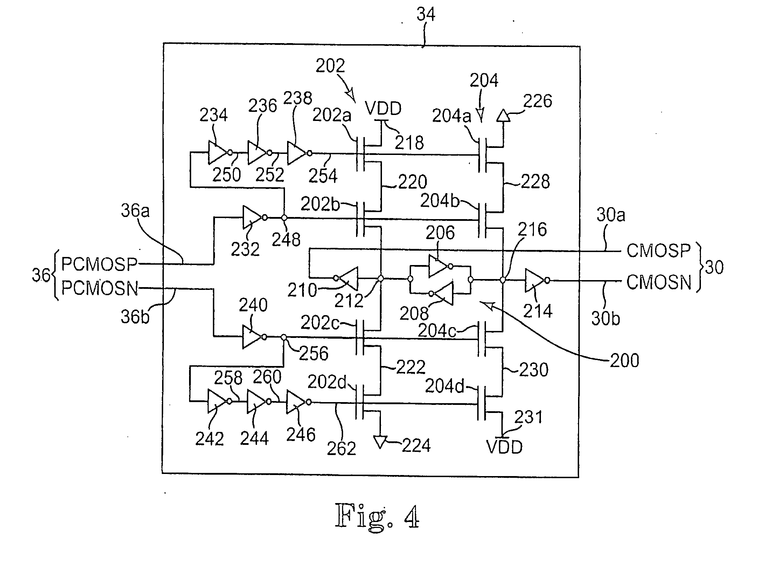

Figure 4 is a diagram illustrating one embodiment of a converter output circuit 34. Output circuit 34 receives differential input signals PCMOS from input circuit 32 via differential input signal path 36 and provides CMOS output signals at CMOS logic levels via output path 30. Output circuit 34 receives positive differential input signal PCMOSP at 36a and negative differential input signal PCMOSN at 36b. Input circuit 32 provides a differential voltage swing in differential input signals PCMOSP at 36a and PCMOSN at 36b that is larger than the differential voltage swing in CML signals at 38. Input circuit 32 also provides a common mode voltage in differential input signals PCMOSP at 36a and PCMOSN at 36b that is substantially equal to a CMOS threshold value. Differential input signals PCMOSP at 36a and PCMOSN at 36b are provided to reliably drive CMOS circuits in output circuit 34. Output circuit 34 provides a positive CMOS output signal CMOSP at 30a and a negative CMOS output signal CMOSN at 30b.

Output circuit 34 includes a cross coupled inverter latch at 200, first switches at 202, and second switches at 204. First switches at 202 selectively couple a low voltage level or a high voltage level to the true side of inverter latch 200 and second switches selectively couple a low voltage level or a high voltage level to the complement side of inverter latch 200. Inverter latch 200 latches in low and high voltage levels to provide latched positive and negative CMOS output signals CMOSP at 30a and CMOSN at 30b.

Inverter latch 200 includes first latch inverter 206 and second latch inverter 208. First latch inverter 206 and second latch inverter 208, are CMOS inverters that respond to and provide CMOS logic levels. The input of first latch inverter 206 is electrically coupled to the input of true side output inverter 210 and the output of second latch inverter 208 via true side path 212. The input of second latch inverter 208 is electrically coupled to the input of complement side output inverter 214 and the output of first latch inverter 206 via complement side path 216. True side output inverter 210 and complement side output inverter 214 are CMOS inverters that respond to and provide CMOS logic levels. The output of true side output inverter 210 provides positive CMOS output signal CMOSP at 30a and the output of complement side output inverter 214 provides negative CMOS output signal CMOSN at 30b.

First switch 202 includes first NMOS transistor 202a, second NMOS transistor 202b, third NMOS transistor 202c, and fourth NMOS transistor 202d. One side of the drain-source path of first NMOS transistor 202a is electrically coupled to power VDD at 218. The other side of the drain-source path of first NMOS transistor 202a is electrically coupled to one side of the drain-source path of second NMOS transistor 202b at 220. The other side of the drain-source path of second NMOS transistor 202b is electrically coupled to one side of the drain-source path of third NMOS transistor 202c and to the input of first latch inverter 206, the input of true side output inverter 210, and the output of second latch inverter 208 via true side path 212. The other side of the drain-source path of third NMOS transistor 202c is electrically coupled to one side of the drain-source path of fourth NMOS transistor 202d at 222. The other side of the drain-source path of fourth NMOS transistor 202d is electrically coupled to a reference, such as ground, at 224.

Second switch 204 includes fifth NMOS transistor 204a, sixth NMOS transistor 204b, seventh NMOS transistor 204c, and eighth NMOS transistor 204d. One side of the drain-source path of fifth NMOS transistor 204a is electrically coupled to a reference, such as ground, at 226. The other side of the drain-source path of fifth NMOS transistor 204a is electrically coupled to one side of the drain-source path of sixth NMOS transistor 204b at 228. The other side of the drain-source path of sixth NMOS transistor 204b is electrically coupled to one side of the drain-source path of seventh NMOS transistor 204c and to the input of second latch inverter 208, the input of complement side output inverter 214, and the output of first latch inverter 206 via complement side path 216. The other side of the drain-source path of seventh NMOS transistor 204c is electrically coupled to one side of the drain-source path of eighth NMOS transistor 204d at 230. The other side of the drain-source path of eighth NMOS transistor 204d is electrically coupled to power VDD at 231.

Output circuit 34 includes positive signal input inverters 232, 234, 236, and 238 that are configured to respond to positive differential input signal PCMOSP at 36a, and negative signal input inverters 240, 242, 244, and 246 that are configured to respond to negative differential input signal PCMOSN at 36b. The positive signal input inverters 232, 234, 236, and 238 and the negative signal input inverters 240, 242, 244, and 246 are CMOS inverters that respond to and provide CMOS logic levels.

The output of inverter 232 is electrically coupled to the input of inverter 234 and the gates of second NMOS transistor 202b and sixth NMOS transistor 204b via gate path 248. The output of inverter 234 is electrically coupled to the input of inverter 236 at 250 and the output of inverter 236 is electrically coupled to the input of inverter 238 at 252. The output of inverter 238 is electrically coupled to the gates of first NMOS transistor 202a and fifth NMOS transistor 204a via gate path 254.

The input of inverter 232 receives positive differential input signal PCMOSP at 36a and inverter 232 inverts the received signal to provide an inverted positive differential input signal to the input of inverter 234 and the gates of second NMOS transistor 202b and sixth NMOS transistor 204b via gate path 248. Three inverter delays later, inverter 238 provides a non-inverted positive differential input signal to the gates of first NMOS transistor 202a and fifth NMOS transistor 204a via gate path 254. If positive differential input signal PCMOSP at 36a is at a high voltage level, first NMOS transistor 202a and fifth NMOS transistor 204a are biased on and second NMOS transistor 202b and sixth NMOS transistor 204b are biased off. As positive differential input signal PCMOSP at 36a transitions to a low voltage level, second NMOS transistor 202b and sixth NMOS transistor 204b are biased on to couple the high voltage level of power VDD to the true side of inverter latch 200 and the low voltage level of a reference, such as ground, to the complement side of inverter latch 200. True side output inverter 210 provides a low voltage level in positive CMOS output signal CMOSP at 30a and complement side output inverter 212 provides a high voltage level in negative CMOS output signal CMOSN at 30b. After three inverter delays, first NMOS transistor 202a and fifth NMOS transistor 204a are biased off to isolate the true side of inverter latch 200 from power VDD and the complement side of inverter latch 200 from the reference. As positive differential input signal PCMOSP at 36a transitions to a high voltage level, second NMOS transistor 202b and sixth NMOS transistor 204b are biased off and three inverter delays later first NMOS transistor 202a and fifth NMOS transistor 204a are biased on, which maintains the voltages on the true and complement sides of inverter latch 200.

The output of inverter 240 is electrically coupled to the input of inverter 242 and the gates of third NMOS transistor 202c and seventh NMOS transistor 204c via gate path 256. The output of inverter 242 is electrically coupled to the input of inverter 244 at 258 and the output of inverter 244 is electrically coupled to the input of inverter 246 at 260. The output of inverter 246 is electrically coupled to the gates of fourth NMOS transistor 202d and eighth NMOS transistor 204d via gate path 262.

The input of inverter 240 receives negative differential input signal PCMOSN at 36b and inverter 240 inverts the received signal to provide an inverted negative differential input signal to the input of inverter 242 and the gates of third NMOS transistor 202c and seventh NMOS transistor 204c via gate path 256. Three inverter delays later, inverter 246 provides a non-inverted negative differential input signal to the gates of fourth NMOS transistor 202d and eighth NMOS transistor 204d via gate path 262. If negative differential input signal PCMOSN at 36b is at a high voltage level, fourth NMOS transistor 202d and eighth NMOS transistor 204d are biased on and third NMOS transistor 202c and seventh NMOS transistor 204c are biased off. As negative differential input signal PCMOSN at 36b transitions to a low voltage level, third NMOS transistor 202c and seventh NMOS transistor 204c are biased on to coupled a low voltage level reference, such as ground, to the true side of inverter latch 200 and a high voltage level power VDD to the complement side of inverter latch 200. True side output inverter 210 provides a high voltage level in positive CMOS output signal CMOSP at 30a and complement side output inverter 212 provides a low voltage level in negative CMOS output signal CMOSN at 30b. After three inverter delays, fourth NMOS transistor 202d and eighth NMOS transistor 204d are biased off to isolate the true side of inverter latch from the reference at 224 and the complement side of inverter latch from power VDD at 231. As negative differential input signal PCMOSN at 36b transitions to a high voltage level, third NMOS transistor 202c and seventh NMOS transistor 204c are biased off and three inverter delays later fourth NMOS transistor 202d and eighth NMOS transistor 204d are biased on. This effectively maintains the voltages on the true and complement sides of inverter latch 200.

In operation, positive differential input signal PCMOSP at 36a is one of a high voltage level or a low voltage level and negative differential input signal PCMOSN at 36b is the other one of the high voltage level or the low voltage level. In steady state, if positive differential input signal PCMOSP at 36a is at a high voltage level and negative differential input signal PCMOSN at 36b is at a low voltage level, first NMOS transistor 202a and fifth NMOS transistor 204a are biased on and second NMOS transistor 202b and sixth NMOS transistor 204b are biased off. Also, third NMOS transistor 202c and seventh NMOS transistor 204c are biased on and fourth NMOS transistor 202d and eighth NMOS transistor 204d are biased off. The true side and the complement side of inverter latch 200 are isolated from power VDD and the reference.

As positive differential input signal PCMOSP at 36a transitions to a low voltage level and negative differential input signal PCMOSN at 36b transitions to a high voltage level, second NMOS transistor 202b and sixth NMOS transistor 204b are biased on to couple the high voltage level of power VDD at 218 to the true side of inverter latch 200 and the low voltage level of the reference at 226 to the complement side of inverter latch 200. Also, third NMOS transistor 202c and seventh NMOS transistor 204c are biased off and the true side of inverter latch 200 remains isolated from the reference at 224 and the complement side of inverter latch 200 remains isolated from power VDD at 231. True side output inverter 210 provides a low voltage level in positive CMOS output signal CMOSP at 30a and complement side output inverter 212 provides a high voltage level in negative CMOS output signal CMOSN at 30b in response to the falling edge of positive differential input signal PCMOSP at 36a. Thus, one state of the positive and negative CMOS output signals CMOSP at 30a and CMOSN at 30b is set in response to the falling edge of positive differential input signal PCMOSP at 36a.

After three inverter delays, first NMOS transistor 202a and fifth NMOS transistor 204a are biased off to isolate the true side of inverter latch 200 from power VDD at 218 and the complement side of inverter latch 200 from the reference at 226. Also, fourth NMOS transistor 202d and eighth NMOS transistor 204d are biased on, but with third NMOS transistor 202c and seventh. NMOS transistor 204c biased off, the true side of inverter latch 200 remains isolated from the reference at 224 and the complement side of inverter latch 200 remains isolated from power VDD at 231.

As positive differential input signal PCMOSP at 36a transitions to a high voltage level and negative differential input signal PCMOSN at 36b transitions to a low voltage level, second NMOS transistor 202b and sixth NMOS transistor 204b are biased off and the true side of inverter latch 200 remains isolated from power VDD at 218 and the complement side of inverter latch 200 remains isolated from the reference at 226. Third NMOS transistor 202c and seventh NMOS transistor 204c are biased on to couple the low voltage level of the reference at 224 to the true side of inverter latch 200 and the high voltage level of power VDD at 231 to the complement side of inverter latch 200. True side output inverter 210 provides a high voltage level in positive CMOS output signal CMOSP at 30a and complement side output inverter 212 provides a low voltage level in negative CMOS output signal CMOSN at 30b in response to the falling edge of negative differential input signal PCMOSN at 36b. Thus, another state of the positive and negative CMOS output signals CMOSP at 30a and CMOSN at 30b is set in response to the falling edge of negative differential input signal PCMOSN at 36b.

After three inverter delays, first NMOS transistor 202a and fifth NMOS transistor 204a are biased on, but with second NMOS transistor 202b and sixth NMOS transistor 204b biased off, the true side of inverter latch 200 remains isolated from power VDD at 218 and the complement side of inverter latch 200 remains isolated from the reference at 226. Fourth NMOS transistor 202d and eighth NMOS transistor 204d are biased off to isolate the true side of inverter latch 200 from the reference at 224 and the complement side of inverter latch 200 from power VDD at 231. The process repeats itself as positive differential input signal PCMOSP at 36a transitions to a low voltage level and negative differential input signal PCMOSN at 36b transitions to a high voltage level.

Output circuit 34 switches positive and negative CMOS output signals CMOSP at 30a and CMOSN at 30b in response to a common edge type in each of the positive and negative differential input signals PCMOSP at 36a and PCMOSN at 36b. Switching positive and negative CMOS output signals CMOSP at 30a and CMOSN at 30b in response to a falling edge type in positive and negative differential input signals PCMOSP at 36a and PCMOSN at 36b reduces pulse width and duty cycle distortion in the positive and negative CMOS output signals CMOSP at 30a and CMOSN at 30b.

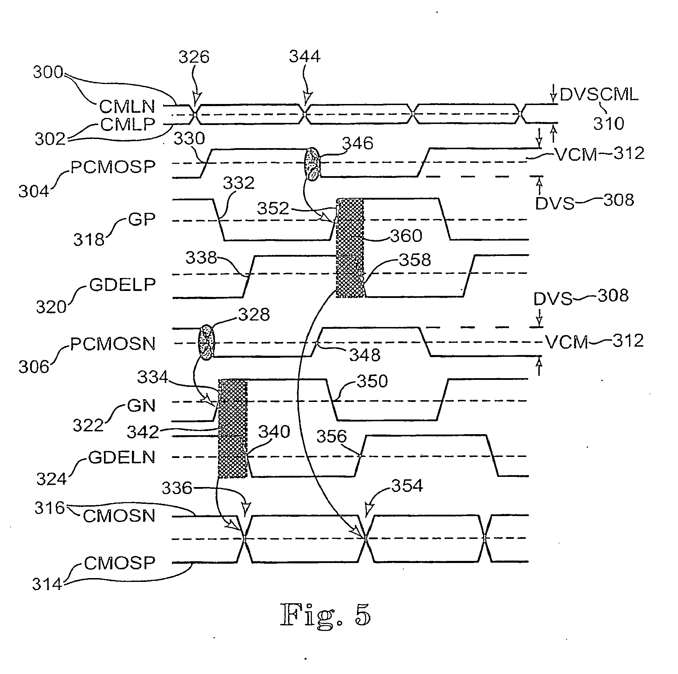

Figure 5 is a timing diagram illustrating the operation of one embodiment of signal converter circuit 28 including input circuit 32 and output circuit 34. Input circuit 32 receives negative CML signal CMLN at 300 and positive CML signal CMLP at 302. Input circuit 32 provides positive differential input signal PCMOSP at 304 and negative differential input signal PCMOSN at 306. Positive and negative differential input signals PCMOSP at 304 and PCMOSN at 306 include a differential voltage swing DVS at 308 that is larger than the CML differential voltage swing DVSCML at 310 in positive and negative CML signals CMLP at 302 and CMLN at 300. Input circuit 32 also provides a common mode voltage VCM at 312 in positive and negative differential input signals PCMOSP at 304 and PCMOSN at 306, which is substantially equal to a CMOS threshold value, such as the threshold value of a CMOS inverter, of VDD divided by 2. Positive and negative differential input signals PCMOSP at 304 and PCMOSN at 306 reliably drive inverters 232 and 240 in output circuit 34.

Output circuit 34 receives positive differential input signal PCMOSP at 304 and negative differential input signal PCMOSN at 306 and provides rail-to-rail positive CMOS output signal CMOSP at 314 and rail-to-rail negative CMOS output signal CMOSN at 316. Inverter 232 receives positive differential input signals PCMOSP at 304 and inverts the received signal to provide positive gate drive signal GP at 318 to the gates of second NMOS transistor 202b and sixth NMOS transistor 204b. Inverter 238 provides positive delayed gate drive signal GDELP at 320 to the gates of first NMOS transistor 202a and fifth NMOS transistor 204a. Inverter 240 receives negative differential input signals PCMOSN at 306 and inverts the received signal to provide negative gate drive signal GN at 322 to the gates of third NMOS transistor 202c and seventh NMOS transistor 204c. Inverter 246 provides negative delayed gate drive signal GDELN at 324 to the gates of fourth NMOS transistor 202d and eighth NMOS transistor 204d. Each of the gate drive signals including the positive gate drive signal GP at 318, positive delayed gate drive signal GDELP at 320, negative gate drive signal GN at 322, and negative delayed gate drive signal GDELN at 324 are provided at CMOS logic levels.

At 326, positive CML signal CMLP at 302 transitions from a low voltage level to a high voltage level and negative CML signal CMLN at 304 transitions from a high voltage level to a low voltage level. In response, negative input transistor 106 transitions from being biased on to biased off and positive input transistor 108 transitions from being biased off to biased on to steer current ISS through second load resistor 104. Negative internal voltage VIN at 118 transitions to a low voltage level and positive internal voltage VIP at 116 transitions to a high voltage level that is substantially equal to buffer voltage VB at 114. First NMOS output transistor 136 is biased on to pull negative differential input signal PCMOSN at 306 to a low voltage level at 328. Second NMOS output transistor 138 is biased off and second PMOS transistor 134 pulls positive differential input signal PCMOSP at 304 to a high voltage level at 330.

In response to positive differential input signal PCMOSP at 304 transitioning to a high voltage level at 330, positive gate drive signal GP at 318 transitions to a low voltage level at 332 to bias off second NMOS transistor 202b and sixth NMOS transistor 204b and the true side of inverter latch 200 remains isolated from power VDD at 218 and the complement side of inverter latch 200 remains isolated from the reference at 226. In response to negative differential input signal PCMOSN at 306 transitioning to a low voltage level at 328, negative gate drive signal GN at 322 transitions to a high voltage level at 334 and third NMOS transistor 202c and seventh NMOS transistor 204c are biased on to couple the low voltage level of the reference at 224 to the true side of inverter latch 200 and the high voltage level of power VDD at 231 to the complement side of inverter latch 200. At 336, positive CMOS output signal CMOSP at 314 transitions to a high voltage level and negative CMOS output signal CMOSN at 316 transitions to a low voltage level in response to the falling edge at 328 of negative differential input signal PCMOSN at 306 and the rising edge at 334 in negative gate drive signal GN at 322. Thus, one state of the positive and negative CMOS output signals CMOSP at 314 and CMOSN at 316 is switched in or set in response to the falling edge at 328 of negative differential input signal PCMOSN at 306.

After three inverter delays, positive delayed gate drive signal GDELP at 320 transitions to a high voltage level at 338 and first NMOS transistor 202a and fifth NMOS transistor 204a are biased on. However, with second NMOS transistor 202b and sixth NMOS transistor 204b biased off, the true side of inverter latch 200 remains isolated from power VDD at 218 and the complement side of inverter latch 200 remains isolated from the reference at 226. Negative delayed gate drive signal GDELN at 324 transitions to a low voltage level at 340 and fourth NMOS transistor 202d and eighth NMOS transistor 204d are biased off to isolate the true side of inverter latch 200 from the reference at 224 and the complement side of inverter latch 200 from power VDD at 231. At 342, between the low to high transition at 334 and the high to low transition at 340, the true side of inverter latch 200 is pulled to the low voltage level and the complement side of inverter latch 200 is pulled to the high voltage level.

At 344, positive CML signal CMLP at 302 transitions from a high voltage level to a low voltage level and negative CML signal CMLN at 304 transitions from a low voltage level to a high voltage level. In response, positive input transistor 108 transitions from being biased on to biased off and negative input transistor 106 transitions from being biased off to biased on to steer current ISS through first load resistor 102. Positive internal voltage VIP at 116 transitions to a low voltage level and negative internal voltage VIN at 118 transitions to a high voltage level that is substantially equal to buffer voltage VB at 114. Second NMOS output transistor 138 is biased on to pull positive differential input signal PCMOSP at 304 to a low voltage level at 346. First NMOS output transistor 136 is biased off and first PMOS transistor 132 pulls negative differential input signal PCMOSN at 306 to a high voltage level at 348.

In response to negative differential input signal PCMOSN at 306 transitioning to a high voltage level at 348, negative gate drive signal GN at 322 transitions to a low voltage level at 350 to bias off third NMOS transistor 202c and seventh NMOS transistor 204c and the true side of inverter latch 200 remains isolated from the reference at 224 and the complement side of inverter latch 200 remains isolated from power VDD at 231. In response to positive differential input signal PCMOSP at 304 transitioning to a low voltage level at 346, positive gate drive signal GP at 318 transitions to a high voltage level at 352 and second NMOS transistor 202b and sixth NMOS transistor 204b are biased on to couple the high voltage level of power VDD at 218 to the true side of inverter latch 200 and the low voltage level of the reference at 226 to the complement side of inverter latch 200. At 354, positive CMOS output signal CMOSP at 314 transitions to a low voltage level and negative CMOS output signal CMOSN at 316 transitions to a high voltage level in response to the falling edge at 346 of positive differential input signal PCMOSP at 304 and the rising edge at 352 in positive gate drive signal GP at 318. Thus, the other state of the positive and negative CMOS output signals CMOSP at 314 and CMOSN at 316 is switched in or set in response to the falling edge at 346 of positive differential input signal PCMOSP at 304.

After three inverter delays, negative delayed gate drive signal GDELN at 324 transitions to a high voltage level at 356 and fourth NMOS transistor 202d and eighth NMOS transistor 204d are biased on. However, with third NMOS transistor 202c and seventh NMOS transistor 204c biased off, the true side of inverter latch 200 remains isolated from the reference at 224 and the complement side of inverter latch 200 remains isolated from power VDD at 231. Positive delayed gate drive signal GDELP at 320 transitions to a low voltage level at 358 and first NMOS transistor 202a and fifth NMOS transistor 204a are biased off to isolate the true side of inverter latch 200 from power VDD at 218 and the complement side of inverter latch 200 from the reference at 226. At 360, between the low to high transition at 352 and the high to low transition at 358, the true side of inverter latch 200 is pulled to the high voltage level and the complement side of inverter latch 200 is pulled to the low voltage level.

The process repeats itself as positive CML signal CMLP at 302 transitions and negative CML signal CMLN at 300 transitions between high and low voltage levels.

Input circuit 32 and output circuit 34 convert positive and negative CML signals CMLP at 302 and CMLN at 300 to positive and negative rail-to-rail CMOS signals CMOSP at 314 and CMOSN at 316. Input circuit 32 and output circuit 34 are configured to be symmetrical circuits, such that duty cycle distortion depends on matching properties of active and passive components and signal converter circuit 28 is independent of process, voltage, and temperature (PVT) parameters to the first order.

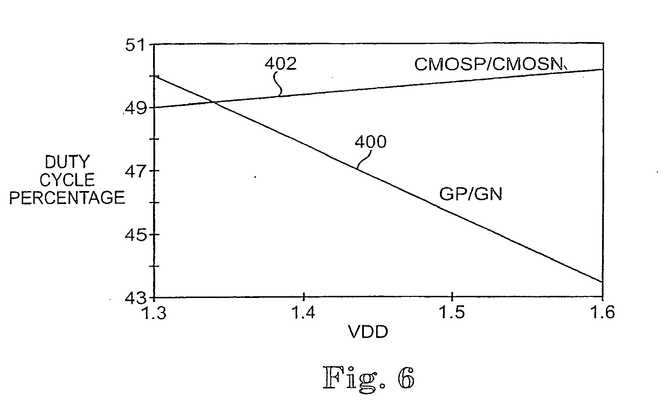

Figure 6 is a diagram illustrating duty cycles in percentage at 400 and 402 of positive gate drive signal GP at 318 and positive CMOS signal CMOSP at 314, respectively, over power VDD. Negative gate drive signal GN at 322 has a duty cycle similar to the duty cycle at 400 of positive gate drive signal GP at 318, and negative CMOS signal CMOSN at 316 has a duty cycle similar to the duty cycle at 402 of positive CMOS signal CMOSP at 314.

The duty cycle at 400 of positive gate drive signal GP at 318 varies between 50% at a VDD of 1.3 volts to 44% at a VDD of 1.6 volts. While the duty cycle at 402 of positive CMOS signal CMOSP at 314 varies between 49% at a VDD of 1.3 volts to 50% at a VDD of 1.6 volts. The duty cycle at 402 of positive CMOS signal CMOSP at 314 is substantially independent of the duty cycle at 400 of positive gate drive signal GP at 318. Instead, the duty cycle at 402 of positive CMOS signal CMOSP at 314 is based on switching in response to a falling edge, such as the falling edge at 328, in negative differential input signal PCMOSN at 306 and a falling edge, such as the falling edge at 346, in positive differential input signal PCMOSP at 304. Switching positive and negative CMOS signals CMOSP at 314 and CMOSN at 316 in response to a common edge type in positive and negative differential input signals PCMOSP at 304 and PCMOSN at 306 reduces pulse width and duty cycle distortion in the positive and negative CMOS output signals CMOSP at 314 and CMOSN at 316.

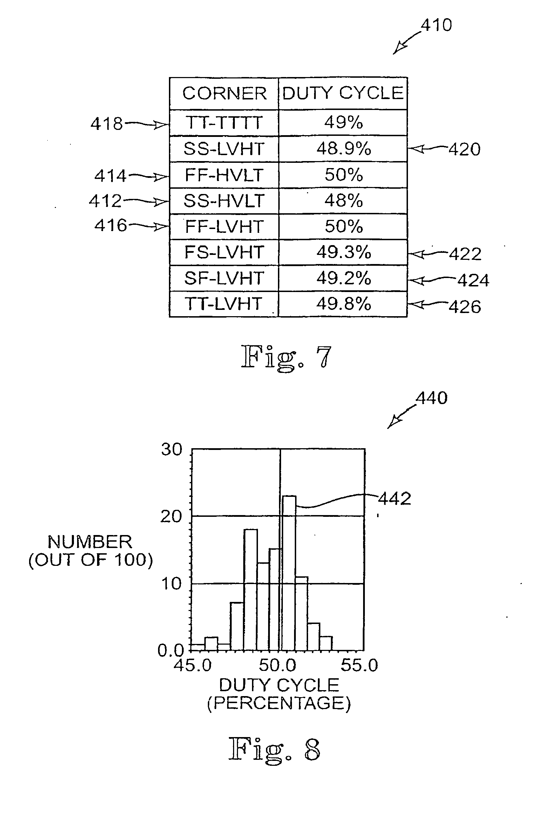

Figure 7 is a PVT corner analysis table 410 for the duty cycle of positive and negative rail-to-rail CMOS output signals CMOSP at 314 and CMOSN at 316 in one embodiment of signal converter circuit 28. In table 410, the first two letters in the left hand column indicate the speed of NMOS and PMOS devices, where the first letter indicates the speed of NMOS devices and the second letter indicates the speed of PMOS devices. The letter T indicates a typical speed, S a slow speed, and F a fast speed. The last four letters in the left hand column indicate the voltage and temperature settings, where the first two of the last four letters indicate the voltage setting and the last two of the last four indicate the temperature setting. The letters TT indicate a typical voltage of 1.5 volts or a typical temperature setting, LV a low voltage setting of 1.3 volts, HV a high voltage setting of 1.6 volts, LT a low temperature setting of 0 degrees Celsius, and HT a high temperature setting of 125 degrees Celsius.

The positive and negative CML signals CMLP at 302 and CMLN at 300 were provided with a 400 milli-volt (mv) differential peak to peak voltage swing and an input edge rate of 100 pico-seconds (ps). The data rate is 4.8 gigabits per second (Gb/s) with an input jitter of zero. Voltage VB at 114 is equal to VDD minus 200 mv, where a typical VDD is 1.5 volts and includes noise of 75 mv from 20 mega-hertz (MHz) to 60 MHz. With positive and negative CML signals CMLP at 302 and CMLN at 300 oscillating at a 50% duty cycle, positive and negative CMOS output signals CMOSP at 314 and CMOSN at 316 oscillate at a duty cycle between 48% and 50% over PVT changes indicated in corner analysis table 410. The duty cycle is 48% at the slow NMOS, slow PMOS, high voltage, and low temperature (SS-HVLT) corner at 412. At the fast NMOS, fast PMOS, high voltage, and low temperature (FF-HVLT) corner at 414 and at the fast NMOS, fast PMOS, low voltage, and high temperature (FF-LVHT) corner at 416, the duty cycle is 50%.

At 418, where the PVT parameters are typical including typical NMOS speeds, typical PMOS speeds, a typical voltage, and a typical temperature (TT-TTTT), the duty cycle is midway between the extremes at 49%. Each of the other PVT corners results in a duty cycle between 48% and 50%. At 420, the slow NMOS, slow PMOS, low voltage, and high temperature (SS-LVHT) corner results in a duty cycle of 48.9%. At 422, the fast NMOS, slow PMOS, low voltage, and high temperature (FS-LVHT) corner results in a duty cycle of 49.3%. At 424, the slow NMOS, fast PMOS, low voltage, and high temperature (SF-LVHT) corner results in a duty cycle of 49.2%, and at 426 the typical NMOS, typical PMOS, low voltage, and high temperature (TT-LVHT) corner results in a duty cycle of 49.8%.

Figure 8 is a diagram illustrating the results of a Monte Carlo analysis 440 that indicates the effects of mismatch in one embodiment of signal converter circuit 28. The positive and negative CML signals CMLP at 302 and CMLN at 300 were provided with a 400 mv differential peak to peak voltage swing and an input edge rate of 100 ps. The data rate is 4.8 Gb/s with an input jitter of zero. Voltage VB at 114 is equal to VDD minus 200 mv, where a typical VDD is 1.5 volts and includes noise of 75 mv from 20 mega-hertz (MHz) to 60 MHz.

With positive and negative CML signals CMLP at 302 and CMLN at 300 oscillating at a 50% duty cycle, the Monte Carlo analysis of signal converter circuit 28 indicates a duty cycle range between 45% and 54% for positive and negative CMOS output signals CMOSP at 314 and CMOSN at 316. Out of 100 results, 69 indicated a duty cycle between 48% and 51 % and the most common duty cycle result was between 50% and 51 % at 442.

Input circuit 32 and output circuit 34 convert positive and negative CML signals CMLP at 302 and CMLN at 300 to positive and negative CMOS signals CMOSP at 314 and CMOSN at 316. Input circuit 32 and output circuit 34 are configured to be symmetrical circuits, such that duty cycle distortion varies little with changes in the active and passive components and signal converter circuit 28 is substantially independent of PVT parameters to the first order.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A signal converter circuit (28), comprising:
an input circuit (32) configured to receive current mode logic signals (38; 300, 302) and provide differential input signals (36; 304, 306) based on the current mode logic signals (38; 300, 302); and
an output circuit (34) configured to receive the differential input signals (36; 304, 306) and provide rail-to-rail output signals (30; 314, 316) based on the differential input signals (36; 304, 306), wherein the output circuit (34) is configured to switch the rail-to-rail output signals (30; 314, 316) in response to a common edge type in each of the differential input signals (36; 304, 306).

2. The signal converter circuit (28) of claim 1, wherein the output circuit (34) comprises:
an inverter latch (200) configured to provide a true side and a complement side to maintain the rail-to-rail output signals (30; 314, 316).

3. The signal converter circuit (28) of claim 2, wherein the output circuit (34) comprises:
first switches (202) configured to provide a high voltage level and a low voltage level to the true side of the inverter latch (200); and
second switches (204) configured to provide the high voltage level and the low voltage level to the complement side of the inverter latch (200), wherein the first switches (202) provide one of the high voltage level and the low voltage level to the true side of the inverter latch (200) and the second switches (204) provide the other one of the high voltage level and the low voltage level to the complement side of the inverter latch (200).

4. The signal converter circuit (28) of claim 3, wherein the first switches (202) and the second switches (204) are switched off subsequent to switching the rail-to-rail output signals (30; 314, 316).

5. The signal converter circuit (28) of any of claims 1-4, wherein the output circuit (34) is configured to switch the rail-to-rail output signals (30; 314, 316) in response to falling edges (328, 346) in each of the differential input signals (36; 304, 306).

6. The signal converter circuit (28) of any of claims 1-5, wherein the input circuit (32) is configured to provide a common mode voltage (312) in the differential input signals (36; 304, 306) that is substantially equal to a threshold value of a complementary metal oxide semiconductor inverter.

7. The signal converter circuit (28) of any of claims 1-6, wherein the input circuit (32) is configured to provide a differential voltage swing (308) in the differential input signals (36; 304, 306) that is larger than current mode logic differential voltage swings (310).

8. A current mode logic signal to rail-to-rail signal converter circuit (28), comprising:
an input circuit (32) configured to receive current mode logic signals (38; 300, 302) and provide differential input signals (36; 304, 306) based on the current mode logic signals (38; 300, 302); and
an output circuit (34) configured to receive the differential input signals (36; 304, 306) and provide rail-to-rail output signals (30; 314, 316) based on the differential input signals (36; 304, 306), wherein the input circuit (32) is configured to provide a common mode voltage (312) in the differential input signals (36; 304, 306) that is substantially equal to a complementary metal oxide semiconductor threshold value and the output circuit (34) is configured to switch the rail-to-rail output signals (30; 314, 316) in response to a common edge type in each of the differential input signals (36; 304, 306).

9. The converter circuit (28) of claim 8, wherein the input circuit (32) is configured to provide a differential voltage swing (308) in the differential input signals (36; 304, 306) that is larger than a current mode logic differential voltage swing (310).

10. The converter circuit (28) of claim 8 or 9, wherein the input circuit comprises:
a differential pair of input transistors (106, 108) configured to receive the current mode logic signals (38; 300, 302) and steer current based on the current mode logic signals (38; 300, 302) to provide common mode voltage shifted output signals; and
a regenerative circuit (130) configured to receive the common mode voltage shifted output signals and to maintain the differential pair of input transistors (106, 108) in saturation.

11. The converter circuit (28) of any of claims 8-10, wherein the input circuit (32) comprises:
a first resistor (102);
a second resistor (104);
a first differential pair of input transistors (106, 108) configured to receive the current mode logic signals (38; 300, 302) and steer a first current based on the current mode logic signals (38; 300, 302), wherein the first current flows through the first resistor (102) to adjust the common mode voltage (312) in the differential input signals (36; 304, 306); and
a second differential pair of input transistors (106, 108) configured to steer a second current through the second resistor (104) to adjust the common mode voltage (312) in the differential input signals (36; 304, 306).

12. The converter circuit (28) of any of claims 8-11, wherein the output circuit (34) comprises:
an inverter latch (200) configured to provide a true side and a complement side and to maintain the rail-to-rail output signals (30; 314, 316);
first switches (202) configured to provide a high voltage level and a low voltage level to the true side of the latch (200); and
second switches (204) configured to provide the high voltage level and the low voltage level to the complement side of the latch (200), wherein the first switches (202) provide one of the high voltage level and the low voltage level to the true side of the latch and the second switches (204) provide the other one of the high voltage level and the low voltage level to the complement side of the latch (200).

13. A signal converter circuit (28), comprising:
means (32) for receiving current mode logic signals (38; 300, 302);
means (32) for providing differential input signals (36; 304, 306) based on the current mode logic signals (38; 300, 302);
means (34) for providing rail-to-rail output signals (30; 314, 316) based on the differential input signals (36; 304, 306); and
means (34) for switching the rail-to-rail output signals (30; 314, 316) in response to a common edge type in each of the differential input signals (36; 304, 306).

14. The signal converter circuit (28) of claim 13, wherein the means (34) for providing rail-to-rail output signals (30; 314, 316) comprises:
means (200) for latching in a true side and a complement side to maintain the rail-to-rail output signals (30; 314, 316).

15. The signal converter circuit (28) of claim 13 or claim 14, wherein the means (34) for switching comprises:
means (202) for switching one of a high voltage level and a low voltage level onto the true side; and
means (204) for switching the other one of the high voltage level and the low voltage level onto the complement side.

16. The signal converter circuit (28) of any of claims 13-15, wherein the means (32) for providing differential input signals (36; 304, 306) comprises:
means for providing a common mode voltage (312) in the differential input signals (36; 304, 306) that is substantially equal to a threshold value of a complementary metal oxide semiconductor inverter; and
means for providing a differential voltage swing (308) in the differential input signals (36; 304, 306) that is larger than current mode logic differential voltage swings (310).

17. The signal converter circuit (28) of any of claims 13-16, wherein the means (32) for providing differential input signals (36; 304, 306) comprises:
means for providing common mode voltage shifted output signals based on the current mode logic signals (38; 300, 302); and
means for maintaining a differential pair of input transistors (106, 108) in saturation.

18. The signal converter circuit (28) of any of claims 13-17, wherein the means (32) for providing differential input signals (36; 304, 306) comprises:
means for adjusting the common mode voltage (312) in the differential input signals (36; 304, 306) via a first current; and
means for steering a second current to adjust the common mode voltage (312) in the differential input signals (36; 304, 306) and increase the differential voltage swing (308).

19. A method of converting current mode logic signals (38; 300, 302) to rail-to-rail signals (30; 314, 316), comprising:
receiving current mode logic signals (38; 300, 302);
providing differential input signals (36; 304, 306) based on the current mode logic signals (38; 300, 302);
outputting rail-to-rail output signals (30; 314, 316) based on the differential input signals (36; 304, 306); and
switching the rail-to-rail output signals (30; 314, 316) in response to a common edge type in each of the differential input signals (36; 304, 306).

20. The method of claim 19, wherein outputting rail-to-rail output signals (30; 314, 316) comprises:
latching in a true side and a complement side to maintain the rail-to-rail output signals (30; 314, 316).

21. The method of claim 19 or claim 20, wherein switching the rail-to-rail output signals (30; 314, 316) comprises:
switching one of a high voltage level and a low voltage level onto the true side; and
switching the other one of the high voltage level and the low voltage level onto the complement side.

22. The method of any of claims 19-21, wherein providing differential input signals (36; 304, 306) comprises:
providing a common mode voltage (312) in the differential input signals (36; 304, 306) that is substantially equal to a threshold value of a complementary metal oxide semiconductor inverter; and
providing a differential voltage swing (308) in the differential input signals (36; 304, 306) that is larger than current mode logic differential voltage swings (310).

23. The method of any of claims 19-22, wherein providing differential input signals (36; 304, 306) comprises:
providing common mode voltage shifted output signals based on the current mode logic signals (38; 300, 302); and
maintaining a differential pair of input transistors (106, 108) in saturation.

24. A method of converting current mode logic signals (38; 300, 302) to rail-to-rail signals (30; 314, 316), comprising:
receiving current mode logic signals (38; 300, 302) at a differential pair of transistors (106, 108);
outputting differential input signals (36; 304, 306) that correspond to the current mode logic signals (38; 300, 302);
shifting a common mode voltage (312) in the differential input signals (36; 304, 306) to be substantially equal to a complementary metal oxide semiconductor threshold value;
increasing differential voltage swing (308) in the differential input signals (36; 304, 306) to be greater than current mode logic differential voltage swings (310); and
outputting rail-to-rail output signals (30; 314, 316) based on the differential input signals (36; 304, 306).

25. The method of claim 24, comprising:
switching the rail-to-rail output signals (30; 314, 316) in response to a common edge type in each of the differential input signals (36; 304, 306).

26. The method of claim 24 or claim 25, wherein outputting rail-to-rail output signals (30; 314, 316) comprises:
latching in a true side and a complement side to maintain the rail-to-rail output signals (30; 314, 316).

27. The method of any of claims 24-26, wherein switching the rail-to-rail output signals (30; 314, 316) comprises:
switching one of a high voltage level and a low voltage level onto the true side; and
switching the other one of the high voltage level and the low voltage level onto the complement side.

28. The method of any of claims 24-27, wherein outputting differential input signals (36; 304, 306) comprises:
maintaining the differential pair of transistors (106, 108) in saturation.
